# EUROPEAN PATENT APPLICATION

(11) **EP 4 170 073 A1**
(43) Date of publication of application: **26.04.2023**
(21) Application number: 21938444.3
(22) Date of filing: 30.04.2021
(51) Int. Cl.: C30B 29/36, C30B 23/00

(54) **HIGH QUALITY SILICON CARBIDE SEED CRYSTAL, SILICON CARBIDE CRYSTAL, SILICON CARBIDE SUBSTRATE, AND PREPARATION METHOD THEREFOR**

(71) Applicant: Tankeblue Semiconductor Co. Ltd, Beijing 102600 (CN); JIANGSU TANKEBLUE SEMICONDUCTOR CO., LTD, Xuzhou, Jiangsu 221000 (CN); Xinjiang Tankeblue Semiconductor Co. Ltd, Shihez, Xinjiang 832000 (CN)
(72) Inventor: PENG, Tonghua, Beijing 102600 (CN); WANG, Bo, Beijing 102600 (CN); ZHAO, Ning, Beijing 102600 (CN); LOU, Yanfang, Beijing 102600 (CN); GUO, Yu, Beijing 102600 (CN); ZHANG, He, Beijing 102600 (CN); LIU, Chunjun, Beijing 102600 (CN); YANG, Jian, Beijing 102600 (CN)
(74) Representative: Müller Schupfner & Partner Patent- und Rechtsanwaltspartnerschaft mbB
(86) International application number: PCT/CN2021/091348
(87) International publication number: WO 2022/226968

(57) **Abstract**

Provided are a high quality silicon carbide seed crystal, a silicon carbide crystal, a silicon carbide substrate, and a preparation method therefor. A high quality silicon carbide seed crystal is prepared, the dopant concentrations of a thermal insulation material, a graphite crucible, and a silicon carbide powder material are controlled, a specific crystal growth process and a wafer machining means are integrated, and a high quality silicon carbide substrate is obtained. The obtained silicon carbide substrate has a high crystalline quality and an extremely low amount of micropipes, screw dislocation density, and compound dislocation density; said substrate also has an extremely low p-type dopant concentration, exhibits superior electrical performance, and has a high surface quality.

## Description

### FIELD

The present disclosure relates to the technical field of semiconductor materials, and in particular to a high-quality silicon carbide seed crystal, a high-quality silicon carbide crystal, a high-quality silicon carbide substrate, and methods for manufacturing the same.

### BACKGROUND

A silicon carbide substrate is also called a silicon carbide wafer, which is shaped as a round thin slice. Generally, the silicon carbide substrate has a diameter of 2 inches, 3 inches, 4 inches, 6 inches, or 8 inches and a thickness ranging from 80 microns to 800 microns. The silicon carbide substrate has excellent properties such as a wide bandgap, high thermal conductivity, high breakdown field strength, and a high saturation drift velocity of electrons, and hence is quite suitable for the fabricating of high-power, high-temperature, and high-frequency power electronics devices and has a broad application prospect in fields such as new energy vehicles, rail transportation, aerospace, and smart grids.

Large-scale practical application of the silicon carbide substrate in the fields such as new energy vehicles, rail transportation, aerospace, and smart grids requires sufficient substrate quality. Herein the "substrate quality" includes three aspects, i.e., crystalline quality of a substrate; second, electrical properties of the substrate, and surface quality of the substrate. Details of these aspects are as follows.

The first aspect is the crystalline quality of the substrate. Currently, crystalline defects in the silicon carbide substrate include micropipes, threading screw dislocations, mixed dislocation (i.e., a mixed dislocation formed by a threading screw dislocation and a basal plane dislocation, a mixed dislocation formed by a threading screw dislocation and a threading edge dislocation, a mixed dislocation formed by a basal plane dislocation and a threading edge dislocation). The crystalline defects in the substrate will result in a failure or performance degradation of devices that are fabricated based on the substrate.

The second aspect is the electrical properties of the substrate. Currently, electrical resistivity of a conductive silicon carbide substrate is regulated mainly through controlling concentration of nitrogen dopants. The nitrogen concentration in the silicon carbide substrate may be as high as 5×10²⁰/cm³, which is highly likely to compensate for p-type impurities in the silicon carbide substrate. Hence, control on a background concentration of the p-type impurities in the silicon carbide substrate would be neglected when preparing the conductive silicon carbide substrate, which results in a high concentration of p-type impurities in the silicon carbide substrate. In order to control the electrical resistivity of the silicon carbide substrate, the concentration of the nitrogen dopants would be increased to compensate for the excessive concentration of the p-type impurities, which eventually result in that concentrations of both the p-type impurities and the nitrogen are too high in the silicon carbide substrate. The immoderate concentrations of the p-type impurities and the nitrogen results in performance deviations of the devices fabricated based on the substrate, and even reduces stability of the devices.

The third aspect is the surface quality of the substrate. Due to poor processing techniques, there would be several scratches on a surface of the silicon carbide substrate. An epitaxial layer needs to be grown on the surface of the silicon carbide substrate before manufacturing the silicon carbide devices. The epitaxial layer is also made of silicon carbide, has the same crystal structure as the substrate, and has a thickness of several microns to tens of microns. A quality of the epitaxial layer is crucial to performances and reliability of the devices that are subsequently fabricated, and has strong dependence on the quality of the substrate, especially on the quality of the substrate surface. In a case that there are scratches of a certain depth on the substrate surface, the scratches would be inherited in the subsequent epitaxy. The scratches in the epitaxial layer would eventually result in problems such as leakage, breakdown, or poor reliability in the fabricated devices.

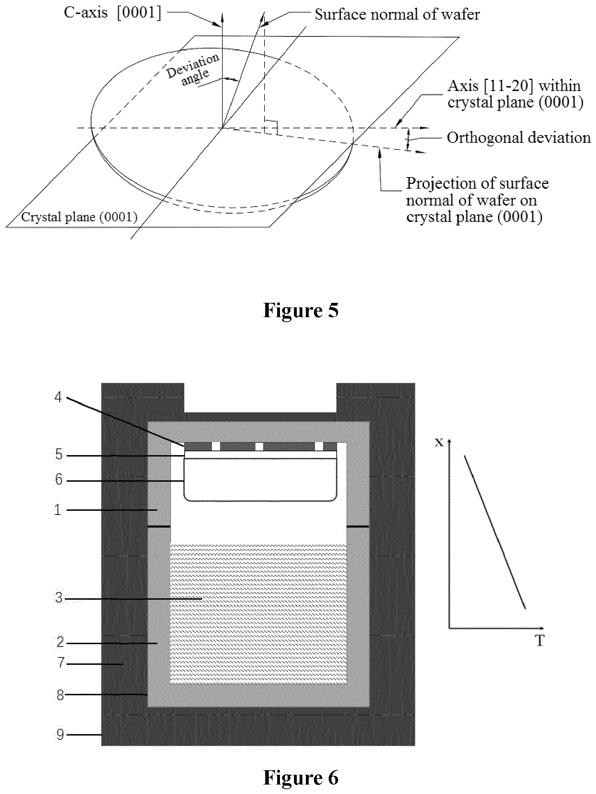

Currently, the silicon carbide crystal is mainly grown through the physical vapor transport method, of which a growth chamber is shown in Figure 6. The silicon carbide (SiC) powder is loaded into a graphite crucible, and a SiC seed crystal is disposed at an upper part of the crucible at which a temperature is lower than that of the SiC powder. The crucible is heated to a temperature ranging from 2100°C to 2400°C, such that the SiC powder sublimes and produces Si₂C, SiC₂ and Si in a gas phase. Due to a temperature gradient, these sublimed substances in the gas phase are transported from a surface of the SiC powder to the SiC seed crystal having lower temperature, and crystallize on the SiC seed crystal thus forming a bulk SiC crystal. At present, the quality of the SiC substrate prepared through the conventional method is unsatisfactory and hampers practical applications.

### SUMMARY

In view of the above, an objective of the present disclosure is to provide a high-quality silicon carbide seed crystal, a high-quality silicon carbide crystal, a high-quality silicon carbide substrate, and methods for manufacturing the high-quality silicon carbide seed crystal, the high-quality silicon carbide crystal, and the high-quality silicon carbide substrate. The high-quality silicon carbide seed crystal and the manufactured silicon carbide substrate are capable to reduce concentrations of defects and impurities in the crystal effectively and improve a surface quality.

A high-quality silicon carbide seed crystal is provided according to embodiments of the present disclosure, including at least a high-quality region, where in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and where an area of the high-quality region is larger than 0.25cm².

In a preferable embodiment, in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1 cm, is smaller than 40 arc seconds; where the area of the high-quality region is larger than 1cm².

In a preferable embodiment, in the high-quality region: the quantity of micropipes is zero, the density of threading screw dislocations is smaller than 50/cm², the density of mixed dislocations is smaller than 20/cm², and the difference between full widths at half maximum of X-ray rocking curves at any two positions, between which a distance is equal to 1cm, is smaller than 40 arc seconds; where the area of the high-quality region is larger than 10cm².

In a preferable embodiment, in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds; where the area of the high-quality region is larger than 50cm².

A method for manufacturing the foregoing high-quality silicon carbide seed crystal is further provided according to embodiments of the present disclosure, which including: step a), performing a first diameter enlargement growth based on a primary seed crystal to obtain a primary grown crystal; step b), processing the primary grown crystal to obtain an intermediate seed crystal which includes only a diameter enlargement region; and step c) performing a second diameter enlargement growth based on the intermediate seed crystal to obtain an advanced seed crystal.

In a preferable embodiment, in the first diameter enlargement growth: an angle of diameter enlargement of the primary seed crystal inside a crucible is controlled to range from 5° to 50°, and temperature field distribution in a growth chamber is controlled to satisfy: along an axial direction, temperature increases gradually from a surface of the primary seed crystal to a surface of a silicon carbide powder with a gradient ranging from 1°C/cm to 10°C/cm; and along a lateral direction, temperature increases gradually from a center of the primary seed crystal to a peripheral of the primary seed crystal with a gradient ranging from 0.5°C/cm to 5°C/cm; in the second diameter enlargement growth: an angle of diameter enlargement of the intermediate seed crystal inside the crucible is controlled to range from 5° to 50°, and the temperature field distribution in the growth chamber is controlling to satisfy: along an axial direction, the temperature increases gradually from a surface of the intermediate seed crystal to a surface of a silicon carbide charge with a gradient ranging from 1°C/cm to 10°C/cm; and along a lateral direction, the temperature increases gradually from a center of the intermediate seed crystal to a peripheral of the intermediate seed crystal with a gradient ranging from 0.5°C/cm to 5°C/cm.

In a preferable embodiment, after the step c), the method further includes step d): comparing a diameter of the advanced seed crystal with a diameter of a silicon carbide substrate to be manufactured; terminating the manufacturing in a case that the diameter of the advanced seed crystal is greater than or equal to the diameter of the silicon carbide substrate to be manufactured; and repeating the second diameter enlargement growth based on the obtained advanced seed crystal in a case that the diameter of the advanced seed crystal is smaller than the diameter of the silicon carbide substrate to be manufactured, until the diameter of the obtained seed crystal is greater than or equal to the diameter of the silicon carbide substrate to be manufactured.

A high-quality silicon carbide crystal is further provided according to embodiments of the present disclosure, where the silicon carbide crystal is formed by using the foregoing high-quality silicon carbide seed crystal or a high-quality silicon carbide seed crystal manufactured according to the foregoing method, and where: the silicon carbide crystal includes at least a high-quality region; in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and an area of the high-quality region is larger than 0.25cm².

In a preferable embodiment, in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1cm, is smaller than 40 arc seconds; where the area of the high-quality region is larger than 1cm².

In a preferable embodiment, in the high-quality region: the quantity of micropipes is zero, the density of threading screw dislocations is smaller than 50/cm², the density of mixed dislocations is smaller than 20/cm², and the difference between full widths at half maximum of X-ray rocking curves at any two positions, between which a distance is equal to 1cm, is smaller than 40 arc seconds; where the area of the high-quality region is larger than 10cm².

In a preferable embodiment, in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds; and the area of the high-quality region is larger than 50cm².

A method for manufacturing the foregoing silicon carbide crystal is further provided according to embodiments of the present disclosure, including: placing a graphite crucible loaded with silicon carbide powder and mounted with the SiC seed crystal into a high-temperature furnace; evacuating the furnace to lower pressure in the furnace and then filling a protective gas into the furnace to adjust the pressure, and simultaneously increasing temperature in the furnace, until reaching target pressure and target temperature; and performing crystal growth under the target pressure and the target temperature to obtain the silicon carbide crystal.

In a preferable embodiment, the target pressure ranges from 100Pa to 5000Pa, and the target temperature ranges from 2050°C to 2250°C.

In a preferable embodiment, in the silicon carbide powder: a concentration of boron impurities is smaller than 5×10¹⁶/cm³ and a concentration of aluminum impurities is smaller than 5×10¹⁵/cm³; in the graphite crucible: a concentration of boron impurities is smaller than 5×10¹⁶/cm³, and a concentration of aluminum impurities is smaller than 5×10¹⁵/cm³; and in an thermal insulation material at periphery of the graphite crucible: a concentration of boron impurities is smaller than 5×10¹⁶/cm³, and a concentration of aluminum impurities is smaller than 5×10¹⁵/cm³.

In a preferable embodiment, the silicon carbide powder is prepared through: step S 1, mixing silicon powder and graphite powder to obtain a mixed powder; and step S2, synthesizing the silicon carbide powder based on the mixed powder under a protective gas.

In a preferable embodiment, the graphite powder is pretreated graphite powder, which is obtained through calcining raw graphite powder in vacuum for a period ranging from 5h to 100h under a temperature ranging from 2200°C to 2400°C, where a total impurity content of the raw graphite powder is smaller than 10ppm; the graphite crucible is a pretreated graphite crucible, which is obtained through calcining an original crucible in vacuum for a period ranging from 5h to 100h under a temperature ranging from 2200°C to 2400°C; and the thermal insulation material is a pretreated thermal insulation material, which is obtained through calcining a raw thermal insulation material under in vacuum for a period ranging from 5h to 100h under a temperature ranging from 2200°C to 2400°C.

A high-quality silicon carbide substrate is further provided according to embodiments of the present disclosure, including at least a high-quality region, where in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and where an area of the high-quality region is larger than 0.25cm².

In a preferable embodiment, in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1cm, is smaller than 40 arc seconds; where the area of the high-quality region is larger than 1cm².

In a preferable embodiment, in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds; the area of the high-quality region is larger than 50cm²; in the silicon carbide substrate, a concentration of boron impurities is smaller than 5×10¹⁵/cm³, and a concentration of aluminum impurities is smaller than 5×10¹⁴/cm³; and a surface normal of the silicon carbide substrate deviates from c-axis orientation by an angle ranging from 1 degree to 5 degrees.

A method for manufacturing the foregoing high-quality silicon carbide substrate is further provided according to embodiments of the present disclosure, including: step K1, processing the foregoing silicon carbide crystal or a silicon carbide crystal manufactured through the foregoing method to obtain a silicon carbide wafer; and step K2, processing the silicon carbide wafer to obtain the silicon carbide substrate.

In a preferable embodiment, the silicon carbide wafer processing includes performing chemical mechanical polishing, where: the chemical mechanical polishing includes first chemical mechanical polishing and second chemical mechanical polishing; the first chemical mechanical polishing utilizes alumina polishing solution and a polyurethane polishing pad having a Shore hardness ranging from 75 to 85; the second chemical mechanical polishing utilizes silicon dioxide polishing solution and a nylon-cloth polishing pad having a Shore hardness ranging 60 to 75; and a ratio of a polishing rate of the first chemical mechanical polishing to a polishing rate of the second chemical mechanical polishing ranges from 10 to 30.

According to embodiments of the present disclosure, the high-quality silicon carbide seed crystal is manufactured, concentrations of impurities in the silicon carbide powder, the graphite crucible, and the thermal insulation material are controlled, and certain crystal growth processes and wafer processing means are combined to obtain the high-quality silicon carbide substrate. The obtained silicon carbide substrate has high crystalline quality, small quantity of micropipes, small density of threading screw dislocations, and small density of mixed dislocations. The obtained silicon carbide substrate further has small concentration of p-type impurities, and hence exhibits excellent electrical properties. The obtained silicon carbide substrate further has high surface quality.

Experimental results have shown that the silicon carbide substrate according to embodiments of the present disclosure has at least a high-quality region. In the high-quality region, the quantity of micropipes is zero, the density of threading screw dislocations is smaller than 30/cm², the density of mixed dislocations is smaller than 5/cm², the difference between full widths at half maximum of X-ray rocking curves at any two positions, between which a distance is equal to 1cm, is smaller than 20 arc seconds. The area of the high-quality region is larger than 50cm². In the obtained silicon carbide substrate, a concentration of boron impurities is smaller than 5×10¹⁵/cm³, a concentration of aluminum impurities is smaller than 5×10¹⁴/cm³, and electrical resistivity of the substrate is smaller than 0.03 Ω·cm. A length of scratches on the surface of the substrate is less than a radius of the substrate.

### BRIEF DESCRIPTION OF THE DRAWINGS

Figure 1 is a morphology image of threading screw dislocations (TSDs), threading edge dislocations (TEDs), and basal plane dislocations (BPDs) in a substrate after etched by molten KOH.
Figure 2 is a schematic diagram of a cross-section of a primary seed crystal and a growing crystal in a first diameter enlargement growth according to an embodiment of the present disclosure.
Figure 3 is a top view of an intermediate seed crystal including an iso-diameter region and a diameter enlargement region.
Figure 4 is a schematic diagram of a cross-section of a primary seed crystal and a growing crystal in a second diameter enlargement growth according to an embodiment of the present disclosure.
Figure 5 is a schematic diagram of a deviation angle between a surface normal and the c-axis of the silicon carbide substrate.
Figure 6 is a schematic diagram of a structure of a growth chamber for growing a silicon carbide crystal through a physical vapor transport method.
Figure 7 is a schematic diagram of a silicon carbide substrate manufactured according to an embodiment of the present disclosure.
Figure 8 is a schematic diagram of distribution of micropipes in a silicon carbide substrate obtained according to an embodiment of the present disclosure.
Figure 9 is a morphology image of micropipes in a silicon carbide substrate obtained according to an embodiment of the present disclosure under transmission polarizing microscopy.
Figure 10 is a graph of density distribution of threading screw dislocations on a silicon carbide substrate obtained according to an embodiment of the present disclosure.
Figure 11 is a graph of electrical properties of a silicon carbide substrate obtained according to an embodiment of the present disclosure.
Figure 12 is a schematic diagram of scratches on a surface of a silicon carbide substrate obtained according to an embodiment of the present disclosure.
Figure 13 is a graph of density distribution of threading screw dislocations on a silicon carbide substrate obtained according to another embodiment of the present disclosure.
Figure 14 is a graph of the electrical properties of a silicon carbide substrate obtained according to another embodiment of the present disclosure.
Figure 15 is a schematic diagram of scratches on a surface of a silicon carbide substrate obtained according to another embodiment of the present disclosure.

### DETAILED DESCRIPTION

### Silicon carbide seed crystal

A high-quality silicon carbide seed crystal is provided according to an embodiment of the present disclosure. The high-quality silicon carbide seed crystal includes at least a high-quality region.

The specifications of the high-quality region are as follows. A quantity of micropipes is zero, a density of threading screw dislocations is smaller than 300/cm². A density of mixed dislocations is smaller than 20/cm². A difference between full widths at half maximum of X-ray rocking curves at any two positions, between which a distance is equal to 1cm, is smaller than 40 arc seconds. An area of the high-quality region is larger than 0.25cm².

Herein the specifications of the high-quality region may further be configured as follows.

The density of threading screw dislocations is preferably smaller than 200/cm², more preferably smaller than 100/cm², more preferably smaller than 50/cm², and more preferably smaller than 30/cm².

The density of mixed dislocations is preferably smaller than 5/cm².

The difference between full widths at half maximum of X-ray rocking curves at any two positions, between which a distance is equal to 1cm, is preferably smaller than 20 arc seconds.

The area of the high-quality region is preferably larger than 1cm², more preferably larger than 5cm², more preferably larger than 10cm², more preferably larger than 50cm².

A shape of the high-quality region includes a triangle, a square, a circle, or a polygon.

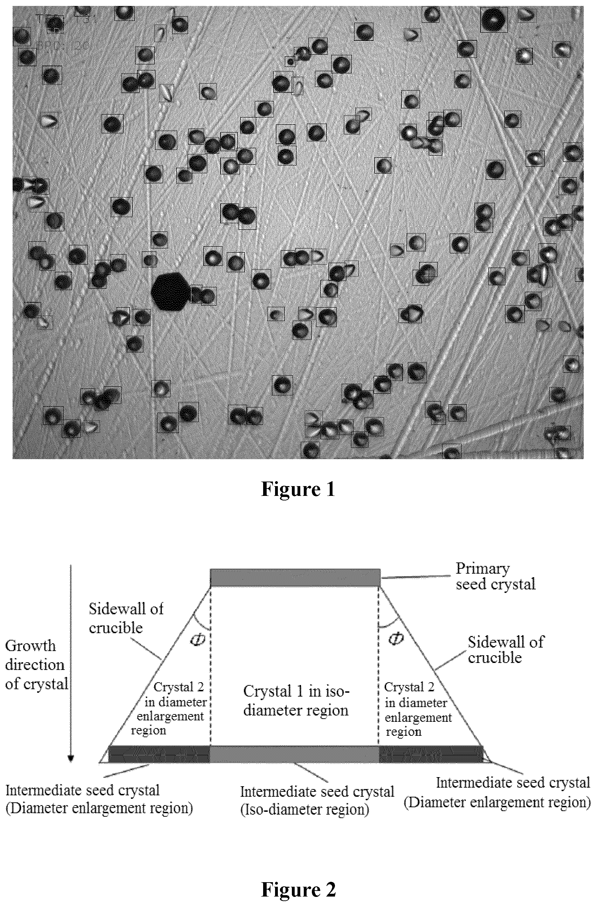

There are various types of crystalline defects in the silicon carbide substrate, and common defects include micropipes, threading screw dislocations, and mixed dislocations formed by any two of a threading screw dislocation, a basal plane dislocation, and a threading edge dislocation. The micropipe is a unique crystallization defect in the silicon carbide substrate, and features in a hollow pipe having a diameter that ranges from several microns to tens of microns and extending along the c-axis. The threading screw dislocation and the threading edge dislocations are threading dislocations extending along the c-axis of the substrate. The basal plane dislocation is a dislocation located within the c-plane of the substrate. After being etched by molten KOH, a surface of the substrate would present corrosion pits of different morphologies, which corresponding to different defects. Generally, a surface normal of the substrate deviates from the c-axis by 4 degrees. After being etched by molten KOH, there would be large hexagons, medium hexagons, small hexagon, and ellipses presented in the surface, which correspond to the micropipes, the threading screw dislocations, the threading edge dislocations, and the basal plane dislocations, respectively. Dislocations of two different types may be aggregated and thus called a mixed dislocation. Reference is made to Figure 1, which is a morphology image of threading screw dislocations (TSDs), threading edge dislocations (TEDs) and basal plane dislocations (BPDs) in a substrate after being etched by molten KOH. Herein, in the mixed dislocation, a distance between geometric centers of corrosion pits corresponding to any two different types of dislocations is less than 30µm, and preferably less than 10µm.

The full width at half maximum (FWHM) of the X-ray rocking curve is used to characterize a dispersion degree of a diffraction beam which is generated from a collimated X-ray incident beam reflected at (0004) surfaces of the silicon carbide substrate. The dispersion degree of the diffraction beam depends on a density of crystalline defects, such as the micropipes, the threading screw dislocations, and the mixed dislocations in the silicon carbide substrate. The higher the density is, the more dispersed the diffraction beam is, and correspondingly the larger the FWHM of the X-ray rocking curve is. Conversely, the more concentrated the diffraction beam is, the smaller the FWHM of the X-ray rocking curve is. Herein, the difference between FWHMs of X-ray rocking curves measured at any two positions, between which a distance is equal to 1cm, on the surface of the substrate is less than 40 arc seconds, and preferably less than 20 arc seconds, which indicates a uniform quality across the whole substrate.

When growing the silicon carbide crystal through the physical vapor transfer method, a large proportion of the defects, i.e., the micropipes, the threading screw dislocation, and the mixed dislocations, in the silicon carbide seed crystal extends along the c-axis into the newly grown crystal. Herein the quality of the seed crystal applied to crystal growth is strictly controlled, in order to obtain a high-quality silicon carbide substrate and reduce densities of micropipes, threading screw dislocations, and mixed dislocations in the silicon carbide substrate.

### Method for manufacturing silicon carbide seed crystal

A method for manufacturing the high-quality silicon carbide seed crystal as described in the foregoing technical solutions is provided according to an embodiment of the present disclosure. The method includes the following steps a) to c)

In step a), a primary seed crystal is subject to a first diameter enlargement growth to obtain a primary grown crystal.

In step b), the primary grown crystal is processed to obtain an intermediate seed crystal which includes only a diameter enlargement region.

In step c), the intermediate seed crystal is subject to a second diameter enlargement growth to obtain an advanced seed crystal.

In the step a), the primary seed crystal is subject to the first diameter enlargement growth to obtain the primary grown crystal.

Herein no special restriction is put on a type and a source of the primary seed crystal, which may be a common commercial SiC seed crystal. Generally, there are a certain quantity of defects such as micropipes, threading screw dislocations, and mixed dislocation in the commercial seed crystal, of which general specifications are as follows. A density of the micropipes ranges from 0.5/cm² to 5/cm², a density of threading screw dislocations ranges from 500/cm² to 1500/cm², a density of mixed dislocations ranges from 30/cm² to 60/cm². Herein the primary seed crystal is subject to two or more processes of diameter enlargement growth, so as to reduce seed defects and improve quality of the seed crystal. Thereby, a high-quality seed crystal can be obtained.

Herein a proper angle of diameter enlargement is selected and a temperature field distribution in a growth chamber is controlled during the diameter enlargement growth, so as to control the seed crystal growth and improve quality of the seed crystal. The angle of diameter enlargement is an angle between a growing direction of the seed crystal and a sidewall of a crucible. Reference is made to Figure 2, which shows a cross-sectional diagram of a primary seed crystal and a growing crystal in a first diameter enlargement growth according to an embodiment of the present disclosure.

Herein during the first diameter enlargement growth, the angle of diameter enlargement of the primary seed crystal in the crucible is selected to range from 5° to 50°, preferably from 15° to 35°, and more preferably from 20° to 30°. In some embodiments of the present disclosure, the angle of diameter enlargement is 30° or 45°.

Herein during the first diameter enlargement growth, distribution of the temperature field in the growth chamber is further controlled, which including controlling an axial (i.e., along the growing direction of the crystal) temperature gradient and a lateral (i.e., perpendicular to the growing direction of the crystal) temperature gradient in the growth chamber.

Specifically, the axial temperature gradient is controlled as follows. The temperature increases gradually from a surface of the primary seed crystal to a surface of a silicon carbide powder with a gradient ranging from 1°C/cm to 10°C/cm. In some embodiments, the gradient ranges from 2°C/cm or 3°C/cm.

Specifically, the lateral temperature gradient is controlled as follows. The temperature increases gradually from a center of the primary seed crystal to a peripheral of the primary seed crystal with a gradient ranging from 0.5°C/cm to 5°C/cm. In some embodiments, the gradient is 2°C/cm.

Herein the angle of diameter enlargement and temperature gradient are controlled as above, which enables not only the iso-diameter growth of the silicon carbide at a surface of the seed crystal but also lateral growth of the silicon carbide along the crucible wall with an angle Φ of diameter enlargement. Reference is made to Figure 2, in which the grown crystal has an iso-diameter region in the middle and a diameter enlargement region at two sides. Since a large proportion of the defects, i.e., micropipes, threading screw dislocations, and mixed dislocations, in the silicon carbide seed crystal would extend along the c-axis into the newly grown crystal, the densities of these defects are still high in the iso-diameter region of the newly grown crystal. On the contrary, the newly grown crystal in the diameter enlargement region grows along a direction which points outward and is perpendicular to a side surface of the newly grown crystal in the iso-diameter region, and hence would not inherit these defects from the primary seed crystal. Thereby, the crystalline quality of the diameter enlargement region is significantly higher than that of the iso-diameter region.

In the step b), the primary grown crystal is processed to obtain the intermediate seed crystal which includes only the diameter enlargement region.

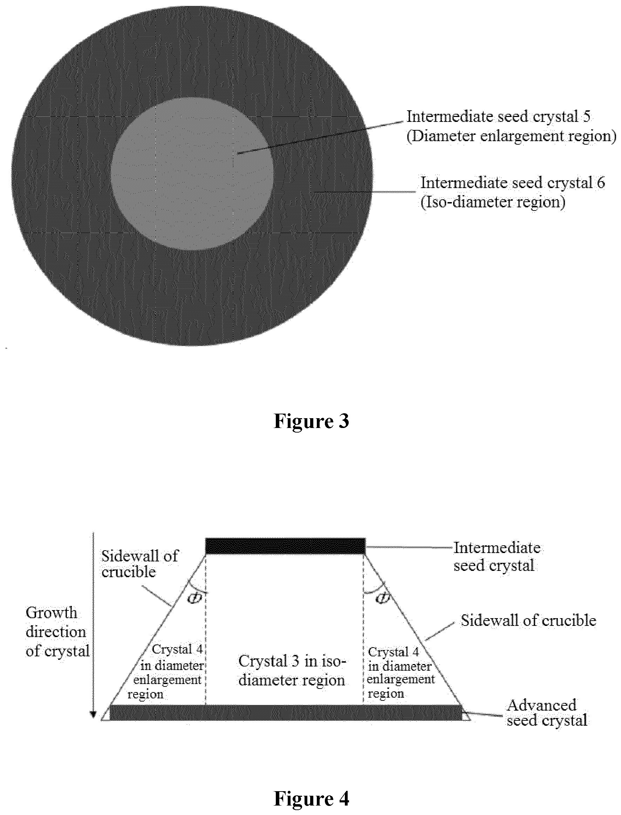

Herein preferably, the primary grown crystal obtained in the step a) is first cut along a direction parallel to the surface of the primary seed crystal (i.e. perpendicular to a growth direction of the crystal). For example, alower part of the obtained primary grown crystal is cut off to obtain an intermediate seed crystal including both the iso-diameter region and the diameter enlargement region. Reference is made to Figure 2. The lowermost part of the obtained crystal is cut off as the intermediate seed crystal including the iso-diameter region and the diameter enlargement region. Reference is made to Figure 3, which 3 shows a top view of the intermediate seed crystal including the iso-diameter region and the diameter enlargement region.

Herein after the cutting, the intermediate seed crystal including the iso-diameter region and the diameter enlargement region is processed to obtain a high-quality intermediate seed crystal which includes only the diameter enlargement region. Herein a manner of the processing method is not specifically limited, as longs as it can separate the iso-diameter region and the diameter enlargement region to obtain a seed crystal from the diameter enlargement region. For example, the seed crystal from the diameter enlargement region is obtained through cutting.

In step c), the intermediate seed crystal is subject to the second diameter enlargement growth to obtain the advanced seed crystal.

Herein growth of the seed crystal is also controlled by selecting an appropriate angle of diameter enlargement and controlling temperature field distribution in the growth chamber during the second diameter enlargement growth, so as to improve quality of the seed crystal. Reference is made to Figure 4, which is a schematic diagram of a cross section of an intermediate seed crystal and a growing crystal in a second diameter enlargement growth according to an embodiment of the present disclosure.

Herein during the second diameter enlargement growth, the angle of diameter enlargement of the intermedia seed crystal in the crucible is selected to range from 5° to 50°, preferably from 15° to 35°, and more preferably from 20° to 30°. In some embodiments of the present disclosure, the angle of diameter enlargement is 30° or 45°.

Herein during the second diameter enlargement growth, distribution of the temperature field in the growth chamber is further controlled, which including controlling the axial temperature gradient and the lateral temperature gradient in the growth chamber.

Specifically, the axial temperature gradient is controlled as follows. The temperature increases gradually from a surface of the intermediate seed crystal to a surface of a silicon carbide powder with a gradient ranging from 1°C/cm to 10°C/cm. In some embodiments, the gradient ranges from 2°C/cm or 3°C/cm.

Specifically, the lateral temperature gradient is controlled as follows. The temperature increases gradually from a center of the intermediate seed crystal to a peripheral of the intermediate seed crystal with a gradient ranging from 0.5°C/cm to 5°C/cm. In some embodiments, the gradient is 2°C/cm.

Herein the angle of diameter enlargement and temperature gradient are controlled as above, which enables not only the iso-diameter growth of the silicon carbide at a surface of the seed crystal but also lateral growth of the silicon carbide along the crucible wall with an angle Φ of diameter enlargement. Since densities of the defects, i.e., micropipes, threading screw dislocations, and mixed dislocations, in the intermediate seed crystal is low, the newly grown crystal in the iso-diameter region would not inherit these defects. Moreover, the newly grown crystal in the diameter enlargement region grows along a direction which points outward and is perpendicular to a side surface of the newly grown crystal in the iso-diameter region, and hence is less likely to inherit these defects. Thereby, high crystalline quality is achieved through the above diameter enlargement growth.

Herein after obtaining the foregoing crystal of high quality through the above second diameter enlargement growth, the high-quality crystal is cut along a direction parallel to the surface of the intermediate seed crystal (i.e., perpendicular to a growth direction of the crystal). For example, a lower part of the obtained intermediate grown crystal is cut off as the advanced seed crystal. Reference is made to Figure 4. The lowermost part of the obtained crystal may serve as the advanced seed crystal.

Herein step d) is preferably performed after the foregoing steps a) to c). In the step d), a diameter of the advanced seed crystal is compared with a diameter of a silicon carbide substrate to be manufactured, in order to determine whether the diameter enlargement growth is to be performed again.

The advanced seed crystal obtained in the step c) is used for manufacturing the high-quality silicon carbide substrate. In order to ensure output efficiency of manufacturing the silicon carbide substrates, a diameter of the seed crystal for growing a silicon carbide crystal is generally slightly larger than or equal to a diameter of the substrate to be manufactured.

The manufacturing based on the seed crystal is terminated, in a case that the diameter of the advanced seed crystal is greater than or equal to the diameter of the silicon carbide substrate to be manufactured.

The second diameter enlargement growth based on the obtained advanced seed crystal is repeated, in a case that the diameter of the advanced seed crystal is smaller than the diameter of the silicon carbide substrate to be manufactured, until the diameter of the obtained seed crystal is greater than or equal to the diameter of the silicon carbide substrate to be manufactured.

In some embodiments, three diameter enlargement growths are performed in total. Conditions of the first and the second diameter enlargement growths are described as above, and a condition of the third diameter enlargement growth is as follows.

The angle of diameter enlargement ranges from 5° to 50°, and preferably from 15° to 35°. In some embodiments, the angle of diameter enlargement is 30° or 45°.

The axial temperature gradient is controlled as follows. The temperature increases gradually from a surface of the advanced seed crystal to a surface of a silicon carbide powder with a gradient ranging from 1°C/cm to 10°C/cm. In some embodiments, the gradient ranges from 2°C/cm or 3°C/cm.

The lateral temperature gradient is controlled as follows. The temperature increases gradually from a center of the advanced seed crystal to a peripheral of the advanced seed crystal with a gradient ranging from 0.5°C/cm to 5°C/cm. In some embodiments, the gradient is 2°C/cm.

In some embodiments, four diameter enlargement growths are performed in total. Conditions of the first to the three diameter enlargement growths are described as above, and a condition of the fourth diameter enlargement growth is as follows.

The angle of diameter enlargement ranges from 5° to 50°, and preferably from 15° to 35°. In some embodiments, the angle of diameter enlargement is 30°.

The axial temperature gradient is controlled as follows. The temperature increases gradually from a surface of the advanced seed crystal to a surface of a silicon carbide powder with a gradient ranging from 1°C/cm to 10°C/cm. In some embodiments, the gradient is 3°C/cm.

The lateral temperature gradient is controlled as follows. The temperature increases gradually from a center of the advanced seed crystal to a peripheral of the advanced seed crystal with a gradient ranging from 0.5°C/cm to 5°C/cm. In some embodiments, the gradient is 2°C/cm.

Herein the diameter of the advanced seed crystal is preferably controlled to be larger than the diameter of the substrate to be manufactured by a difference ranging from 0.5mm to 10mm, and more preferably from 1 mm to 5mm.

The SiC seed crystal of high quality is manufactured according to the above method. Using such seed crystal to manufacture a silicon carbide substrate can reduce crystal defects in the silicon carbide substrate effectively and achieve high quality in the silicon carbide substrate.

### Silicon carbide crystal

A silicon carbide crystal of high quality is manufactured according to embodiments of the present disclosure. The silicon carbide crystal is formed by using the foregoing high-quality silicon carbide seed crystal or a high-quality silicon carbide seed crystal manufactured according to the foregoing method.

The silicon carbide crystal includes at least a high-quality region.

Specifications of the high-quality region are as follows. A quantity of micropipes is zero. A density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds. An area of the high-quality region is larger than 0.25cm².

Herein the specifications the high-quality region are as follows.

The density of threading screw dislocations is preferably smaller than 200/cm², more preferably smaller than 100/cm², more preferably smaller than 50/cm², and most preferably smaller than 30/cm².

The density of mixed dislocations is preferably smaller than 5/cm².

A difference between full widths at half maximum of X-ray rocking curves at any two positions, between which a distance is equal to 1cm, is preferably smaller than 20 arc seconds.

The area of the high-quality region is preferably larger than 1cm², more preferably larger than 5cm², more preferably larger than 10cm², and most preferably larger than 50cm².

A shape of the high-quality region includes a triangle, a square, a circle, or a polygon.

Herein a concentration of boron impurities in the silicon carbide crystal is preferably smaller than 5×10¹⁶/cm³, more preferably smaller than 1×10¹⁶/cm³, and most preferably smaller than 5×10¹⁵/cm³.

Herein a concentration of aluminum impurities in the silicon carbide crystal is preferably smaller than 5×10¹⁵/cm³, more preferably smaller than 1×10¹⁵/cm³, and most preferably smaller than 5×10¹⁴/cm³.

Herein a surface normal of the silicon carbide crystal deviates from the c-axis by an angle ranging from 0 to 8 degrees, and preferably 1 degree to 5 degrees.

Silicon carbide substrates have various crystal structures, of which common ones includes the 4H type and the 6H type. These two structures are identical within the c-plane, and differs in a direction along the c-axis. Along the c-axis, a stacking period of the 4H crystal structure consists of four Si-C diatomic layers stacked in an A-B-C-B manner, while a stacking period of the 6H crystal structure consists of four Si-C diatomic layers stacked in an A-B-C-A-C-B manner. At present, large-scale commercialized silicon carbide substrates are of the 4H structure, such that the epitaxial layer obtained in subsequent processes maintains the 4H structure. A surface normal of the silicon carbide substrate deviates from the c-axis of such substrate by a certain angle. Herein the deviation angle ranges from 0 to 8 degrees, preferably ranges from 1 degree to 5 degrees, and more is 4 degrees. Reference is made to Figure 5, which shows a schematic diagram of a deviation angle between a surface normal of the silicon carbide substrate and the c-axis of such substrate.

### Method for manufacturing silicon carbide crystal

A method for manufacturing the silicon carbide crystal is provided according to an embodiment of the present disclosure. The method includes following steps.

A graphite crucible loaded with silicon carbide powder and mounted with a SiC seed crystal is placed into a high-temperature furnace. The furnace is evacuated to lower pressure in the furnace and then a protective gas is filled into the furnace to adjust the pressure, and simultaneously temperature in the furnace is increased, until target pressure and target temperature are reached. Crystal growth is performed under the target pressure and the target temperature to obtain the silicon carbide crystal.

Reference is made to Figure 6, which shows a schematic diagram of a structure of a growth chamber for growing a silicon carbide crystal through a physical vapor transport method. Reference numerals are as follows: 1 represents a graphite lid, 2 represents a graphite crucible (1 and 2 form the whole graphite crucible), 3 represents silicon carbide powder, 4 represents an adhesive, 5 represents a SiC seed crystal, 6 represents a growing crystal, 7 represents a thermal insulation material, 8 represents an inner side of the thermal insulation material, and 9 represents an outer side of the thermal insulation material. Specifically, the SiC seed crystal is fixed at the top on an inner side of the graphite lid adhesively or mechanically, the silicon carbide powder is loaded into the graphite crucible, and the graphite lid having the fixed SiC seed crystal is mounted on the graphite crucible. Then, the graphite crucible with the lid is placed into the high-temperature furnace for the crystal growth. A distance between the surface of the silicon carbide powder and the SiC seed crystal ranges preferably 20mm to 60mm. In some embodiments, the distance is 30mm or 40mm.

The bandgap of the silicon carbide substrate is 3.2eV, and the intrinsic silicon carbide substrate is not conductive. Since both silicon and carbon in the silicon carbide substrate are tetravalent elements, nitrogen doping is usually utilized to modulate electrical resistivity of the silicon carbide substrate and thereby obtain a conductive silicon carbide substrate. Since nitrogen is a pentavalent element, nitrogen may provide an additional electron for conductivity, thus obtaining a conductive silicon carbide substrate. In a case that a concentration of p-type impurities such as elements boron and aluminum in the silicon carbide substrate is high, the trivalent boron and aluminum each would capture electrons, such that there are less electrons involved for conductivity in silicon carbide substrate, and hence electrical resistivity of the silicon carbide substrate increases. In order to control the electrical resistivity of the conductive silicon carbide substrate, a quantity of nitrogen dopants is usually increased to compensate for the p-type impurities in the silicon carbide substrate and maintain the electrical resistivity unchanged. As a result, both the concentration of p-type impurities and concentration of nitrogen are high in the conductive silicon carbide substrate. The high concentrations of p-type impurities and nitrogen would result in a poor performance of devices fabricated based on the substrate, and even reduce stability of the devices. Herein a concentration of the p-type impurities, which mainly includes boron and aluminum, in the conductive silicon carbide substrate is strictly controlled, so as to obtain a high-quality conductive silicon carbide substrate.

In the physical vapor transport method, raw and consumable materials for growing the silicon carbide crystal mainly include a silicon carbide powder, a graphite crucible, and a thermal insulation material wrapped around the graphite crucible. Temperature reaches as high as 2100°C during the crystal growth. At such temperature, the impurities, i.e., boron and aluminum, in the silicon carbide powder, the graphite crucible and the thermal insulation material would sublimate into gases and enter the newly grown crystal during the crystal growth, which affects electrical properties of a product. Herein concentrations of impurities, i.e., boron and aluminum, in the silicon carbide powder, the graphite crucible, and the thermal insulation material are strictly controlled, so as to control these impurities in the newly grown crystal.

### I. Silicon carbide powder

Herein the silicon carbide powder is controlled as follows. A concentration of boron impurities is preferably smaller than 5×10¹⁶/cm³, more preferably smaller than 1×10¹⁶/cm³, and more preferably smaller than 5×10¹⁵/cm³. A concentration of aluminum impurities is preferably smaller than 5×10¹⁵/cm³, more preferably smaller than 1×10¹⁵/cm³, and most preferably smaller than 5×10¹⁴/cm³.

Herein granularity of the silicon carbide powder preferably ranges from 200µm to 5000µm.

Here the silicon carbide powder is preferably fabricated through following steps S1 and S2.

In step S1, silicon powder and graphite powder are mixed to obtain a mixed powder.

In step S2, the silicon carbide powder is synthesized based on the mixed powder under a protective gas.

Following details concern the step S1.

Herein the silicon powder is preferably a high purity silicon powder, of which a purity of preferably larger than or equal to 99.99999%. Herein the granularity of the silicon powder ranges preferably from 10µm to 500µm. Herein a source of the silicon powder is not specifically limited, and the silicon powder is generally a commercial product.

Herein the graphite powder is preferably pretreated graphite powder. The pretreatment is preferably as follows. Raw graphite powder is calcined under vacuum. The raw graphite powder is preferably high purity graphite powder, of which a total concentration of impurities is smaller than 10ppm. Herein a source of the raw graphite powder is not specifically limited, and the raw graphite powder may be a commercial product. Temperature of the calcination ranges preferably from 2200°C to 2400°C. In some embodiments, the temperature of the calcination is 2200°C or 2250°C. Duration of the calcination ranges preferably from 5h to 100h. In some embodiments, the duration of the calcination is 10h or 30h. Specifically, after the graphite powder is placed into the high-temperature furnace, the furnace is evacuated, and a vacuum pump keeps operating to maintain the vacuum. Then, the temperature in the furnace is raised to the target temperature to keep the calcination.

Herein following operations are preferably performed when keeping the calcination for the duration ranging from 5h to100h, in order to further improve an effect of removing boron and aluminum impurities. The vacuum pump is first shut down to stop the evacuation, an inert gas is filled to achieve pressure ranging from 1000Pa to 70000Pa, and the pressure is kept for another duration ranging from 1min to 60min. Then, the vacuum pump is turned on again and keeps operating to provide the vacuum, and the calcination continues. The inert gas is preferably argon. In some embodiments, the above pressure is 50000Pa. In some embodiments, the other duration is 10min.

Herein the above pretreatment is capable to achieve the graphite powder having a concentration of boron impurities smaller than 5×10¹⁶/cm³, more preferably smaller than 5×10¹⁵/cm³, and having a concentration of aluminum impurities smaller than 5×10¹⁵/cm³, more preferably smaller than 5×10¹⁴/cm³.

Herein a mass ratio of the silicon powder to the graphite powder range preferably from 1.00: 1 to 1.05:1. In some embodiments, the mass ratio is 1.00:1 or 1.05: 1.

Herein the silicon powder and graphite powder are uniformly mixed and then placed into the graphite crucible in the high-temperature furnace. Preferably, the furnace is first evacuated and then filled with a protective gas to reach pressure ranging from 100Pa to 50000Pa, and afterwards is heated to the target temperature for the synthesis. In some embodiments, the above pressure is 1000Pa or 5000Pa.

Herein the temperature of the synthesis preferably ranges from 1800°C to 2200°C. In some embodiments, the temperature is 1850°C or 1900°C. Duration of the synthesis ranges preferably from 5h to 20h. In some embodiments, the duration is 8h or 12h. The protective gas is preferably argon. Through the above synthesis, the silicon powder and the graphite powder react in a solid phase under high temperature, which obtains the silicon carbide powder.

Herein the above manufacturing method is adopted to fabricate the silicon carbide power, which can reduce the concentrations of boron impurities and aluminum impurities in the silicon carbide powder effectively and obtain silicon carbide powder having purity meeting the foregoing requirement. Using such powder as the raw material for growing the silicon carbide substrate can reduce the boron impurities and the aluminum impurities in products and improve electrical properties of the products.

### II. SiC seed crystal

Herein the SiC seed crystal is the foregoing high-quality SiC seed crystal or a high-quality SiC seed crystal manufactured through the foregoing method for manufacturing the foregoing high-quality SiC seed crystal.

### III. Graphite crucible

Herein the graphite crucible is preferably a pretreated graphite crucible. Herein the pretreated graphite crucible is subject to pretreatment same as the foregoing pretreatment for the pretreated graphite powder. That is, an original graphite crucible is calcined under vacuum. Temperature of the calcination preferably ranges from 2200°C to 2400°C. In some embodiments, the temperature of the calcination is 2200°C or 2250°C. Duration of the calcination ranges preferably from 5h to 100h. In some embodiments, the duration of the calcination is 10h or 30h. Specifically, after the graphite crucible is placed into the high-temperature furnace, the furnace is evacuated and then the vacuum pump keeps operating to maintain the vacuum, and afterwards is heated to the target temperature to keep the calcination.

Herein following operations are preferably performed when keeping the calcination for the duration ranging from 5h to100h, in order to further improve an effect of removing boron and aluminum impurities. The vacuum pump is first shut down to stop the evacuation, an inert gas is filled to achieve pressure ranging from 1000Pa to 70000Pa, and the pressure is kept for another duration ranging 1min to 60min. Then, the vacuum pump is turned on again and keeps operating to provide the vacuum, and the calcination continues. The inert gas is preferably argon. In some embodiments, the above pressure is 50000Pa. In some embodiments, the other duration is 10min.

### IV Insulation material

Herein the thermal insulation material is mainly a carbon material, such as a graphite soft felt or a graphite hard felt. Herein the thermal insulation material is preferably a pretreated thermal insulation material. Herein the pretreated thermal insulation material is subject to pretreatment same as the foregoing pretreatment for the pretreated graphite powder. That is, an original thermal insulation material is calcined under vacuum. Temperature of the calcination preferably ranges from 2200°C to 2400°C. In some embodiments, the temperature of the calcination is 2200°C or 2250°C. Duration of the calcination ranges preferably from 5h to 100h. In some embodiments, the duration of the calcination is 10h or 30h. Specifically, after the thermal insulation material is placed into the high-temperature furnace, the furnace is evacuated and then the vacuum pump keeps operating to maintain the vacuum, and afterwards is heated to the target temperature to keep the calcination

Herein following operations are preferably performed when keeping the calcination for the duration ranging from 5h to100h, in order to further improve an effect of removing boron and aluminum impurities. The vacuum pump is first shut down to stop the evacuation, an inert gas is filled to achieve pressure ranging from 1000Pa to 70000Pa, and the pressure is kept for another duration ranging 1min to 60min. Then, the vacuum pump is turned on again and keeps operating to provide the vacuum, and the calcination continues. The inert gas is preferably argon. In some embodiments, the above pressure is 50000Pa. In some embodiments, the other duration is 10min. The foregoing treatment can remove the boron impurities and the aluminum impurities in the thermal insulation material effectively and obtain a thermal insulation material having high purity. Moreover, an inner side of the thermal insulation material (i.e., the side having a surface in contact with the graphite crucible) and an outer side of the thermal insulation material need to be respectively calcined at high temperature, so as to improve the purity of the thermal insulation material. Thereby, purity of the thermal insulation material is thoroughly improved.

### V Processing

After the graphite crucible with the lid is placed into the high-temperature furnace, the furnace is first vacuumed to low pressure and then a protective gas is filled into the furnace to adjust the pressure, and simultaneously the temperature in the furnace is raised, until the target pressure and the target temperature are reached. The crystal growth is performed under such pressure and such temperature to obtain the silicon carbide crystal.

Herein the furnace is evacuated to preferably below 10Pa, and the vacuum pump keeps operating to maintain the vacuum. Afterwards, the furnace is heated to temperature which preferably ranges from 500°C to 1000°C. In some embodiments, such temperature is 800°C or 1000°C. After the heating, such temperature is maintained for a period which preferably ranges from 1h to 5h. In some embodiments, such period is 1h or 3h.

Herein following operations are preferably performed when keeping maintaining the temperature for the period ranging from 5h to 100h, in order to further improve an effect of removing volatile components in the insulating material, the graphite crucible, and the silicon carbide power. The vacuum pump is first shut down to stop the evacuation, an inert gas is filled to achieve pressure ranging from 1000Pa to 70000Pa, and the pressure is kept for duration ranging 1min to 60min. Then, the vacuum pump is turned on again and evacuates to pressure lower than 1Pa, and then keeps operating to provide the vacuum. The processing under high temperature continues. In some embodiments, the above pressure is 50000Pa or 70000Pa. In some embodiments, the duration is 5min or 10min.

Herein after the volatile components are removed from the thermal insulation material, the graphite crucible, and the silicon carbide powder, the vacuum pump is shut down to stop evacuating the vacuum tube, and an inert gas is filled into the furnace to reach a pressure ranging from 5000Pa to 70000Pa (in some embodiments, the pressure is 50000Pa or 70000Pa). Temperature in the furnace is raised to crystal growth temperature and maintained for duration ranging from 1h to 10h (in some embodiments, the duration is 2h or 2.5h). Then, the pressure in the furnace is lowered to pressure required for crystal growth, so as to start the crystal growth. The pressure required for the crystal growth ranges from 100Pa to 5000Pa, and preferably from 100Pa to 1500Pa. In some embodiments, the pressure is 1500Pa or 2000Pa. The crystal growth temperature ranges from 2050°C to 2250°C, and preferably from 2100°C to 2200°C. In some embodiments, the temperature is 2150°C or 2220°C. After the growth, the crystal is subject to in-situ annealing. After the in-situ annealing, the temperature in the furnace is lowered to room temperature, and the high-temperature furnace is opened to fetch the crystal, i.e., the silicon carbide crystal product.

Herein the above method for manufacture the silicon carbide crystal can reduce concentrations of defects and the impurities in the crystal effectively, thereby improving quality of the silicon carbide crystal.

### Silicon carbide substrate

A silicon carbide substrate is also called a silicon carbide wafer, which is shaped as a round thin slice. Generally, the silicon carbide substrate has a diameter of 2 inches, 3 inches, 4 inches, 6 inches, or 8 inches and a thickness ranging from 80 microns to 800 microns. Commercial silicon carbide substrates usually have a certain quantity of defects, i.e., the micropipes, the threading screw dislocations, and the mixed dislocations. Specifications of the commercial silicon carbide are as follows. A density of micropipes ranges from 0.5/cm² to 5/cm², a density of threading screw dislocations ranges from 500/cm² to 1500/cm², a density of mixed dislocations ranges from 30/cm² to 60/cm², and a length of scratches on a surface ranges from 1R to 6R (where R refers to a radius of the substrate).

A silicon carbide substrate of high quality is provided according to an embodiment of the present disclosure. The silicon carbide substrate includes at least a high-quality region.

Specifications of the high-quality region are as follows. A quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds.

An area of the high-quality region is larger than 0.25cm².

Herein specifications of the high-quality region are as follows.

The density of threading screw dislocations is preferably smaller than 200/cm², more preferably smaller than 100/cm², more preferably smaller than 50/cm², and more preferably smaller than 30/cm².

The density of mixed dislocations is preferably smaller than 5/cm².

The difference between full widths at half maximum of X-ray rocking curves at any two positions, between which a distance is equal to 1cm, is preferably smaller than 20 arc seconds.

The area of the high-quality region is preferably larger than 1cm², more preferably larger than 5cm², more preferably larger than 10cm², and most preferably larger than 50cm².

A shape of the high-quality region includes a triangle, a square, a circle, or a polygon.

Herein a concentration of boron impurities in the silicon carbide substrate is preferably smaller than 5×10¹⁶/cm³, more preferably smaller than 1×10¹⁶/cm³, and most preferably smaller than 5×10¹⁵/cm³.

Herein a concentration of aluminum impurities in the silicon carbide substrate is preferably smaller than 5×10¹⁵/cm³, more preferably smaller than 1×10¹⁵/cm³, and most preferably smaller than 5×10¹⁴/cm³.

Herein a surface normal of the silicon carbide substrate deviates from the c-axis by an angle ranging from zero to 8 degrees, and preferably from 1 degree to 5 degrees.

Herein electrical resistivity of the silicon carbide substrate is smaller than 0.03Ω·cm, and preferably smaller than 0.023Ω·cm.

Herein the length of the scratches on the surface of the silicon carbide substrate is less than the radius of the substrate.

### Method for manufacturing silicon carbide substrate

A method for manufacturing a silicon carbide substrate of high quality is provided according to an embodiment of the present disclosure. The method includes following steps K1 and K2.

In step K1, a silicon carbide crystal is processed to obtain a silicon carbide wafer.

In step K2, the silicon carbide wafer is processed to obtain the silicon carbide substrate.

The silicon carbide crystal is the silicon carbide crystal described in the foregoing technical solution, or a silicon carbide crystal manufacture through the foregoing method for manufacturing the silicon carbide crystal.

Details of the step K1 are as follows.

Herein a manner of processing the crystal is not specifically limited as long as it is a conventional process in the field. The processing includes: cylindrical grinding, flat surface grinding, single-crystal orientation, wafer flat processing, and multi-wire cutting. A slice is obtained through the processing.

Details of the step K2 are as follows.

Herein the processing on the wafer includes chemical mechanical polishing. Herein the processing on the wafer further includes double-side grinding and mechanical polishing, which are performed before the chemical mechanical polishing. Herein a manner of the double-side grinding and the mechanical polishing is not specifically limited, as long as it is a conventional operation for those skilled in the art.

Herein the chemical mechanical polishing preferably includes a first chemical mechanical polishing and then a second chemical mechanical polishing. Chemical mechanical polishing is a technique combining a chemical reaction and mechanical processing. First, a surface material of a workpiece reacts chemically with a component in the polishing solution, and thereby a soft layer which is easier to remove is generated. Then, the soft layer is mechanically removed by using an abrasive in a polishing solution and a polishing pad, such that a new surface of the workpiece is exposed. Hence, the surface of the workpiece is polished through both the chemical reaction and the mechanical processing.

In the first chemical mechanical polishing, the polishing solution used is alumina polishing solution; the alumina polishing solution refers to the polishing solution in which the abrasive particles are aluminum oxide. In the present disclosure, the source of the alumina polishing solution is no special restrictions, which may be a general commercially available product.

In the first chemical mechanical polishing, an alumina polishing solution and a polyurethane polishing pad having a Shore hardness ranging from 75 to 85 are utilized.

In the first chemical mechanical polishing, pressure applied by a polishing head ranges preferably from 100g/cm² to 450g/cm². In some embodiments, the pressure is 230g/cm² or 400g/cm². The polishing rate ranges preferably from 0.5 micron/hour to 2 microns/hour. In some embodiments, the polishing rate is 1.1 microns/hour or 1.5 microns/hour.

In the second chemical mechanical polishing, a silicon dioxide polishing solution is utilized. The silicon dioxide polishing solution refers to a polishing solution in which abrasive particles are silicon dioxide. Herein a source of the silicon dioxide polishing solution is not specifically limited, and the silicon dioxide polishing solution may be a common commercial product.

In the second chemical mechanical polishing, a nylon cloth polishing pad is utilized. The Shore hardness of such polishing pad preferably ranges from 60 to 75.

In the second chemical mechanical polishing, pressure of a polishing head ranges preferably from 150g/cm² to 400g/cm². In some embodiments, the pressure is 350g/cm² or 400g/cm². The polishing rate ranges preferably from 20 nanometers/hour to 100 nanometers/hour. In some embodiments, the polishing rate is 25 nanometers/hour or 35 nanometers/hour.

Herein the polishing rate of the first chemical mechanical polishing ranges from 10 times to 30 times the polishing rate of the second chemical mechanical polishing.

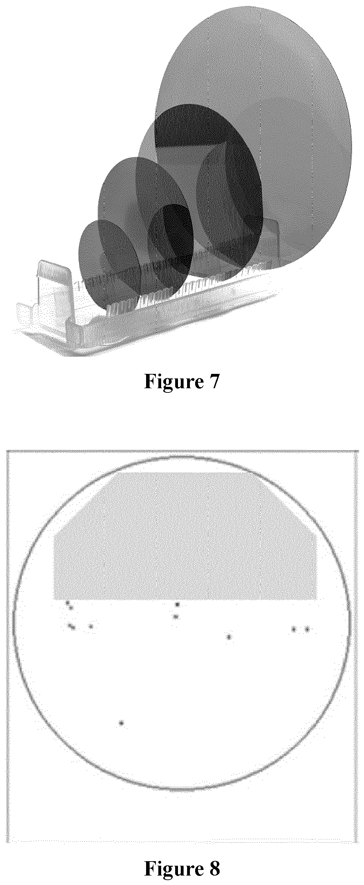

Herein the above processing can improve quality of the substrate surface and obtain a high-quality surface having scratches of which a length is smaller than the radius of the substrate. Such manufacturing method can be used to manufacture silicon carbide substrates of various sizes, which may specifically include diameters of 2 inches, 3 inches, 4 inches, and 6 inches, and a thickness ranging from 80 microns to 800 microns. Reference is made to Figure 7, which shows a schematic diagram of a silicon carbide substrate manufactured according to embodiments of the present disclosure.

The silicon carbide substrate manufactured according to embodiments of the present disclosure has the following beneficial effects.

First, the crystalline quality is high, and the quantity of micropipes is quite small, the density of threading screw dislocations is quite low, and the density of mixed dislocations is quite low.

Second, the concentration of p-type impurities is quite low, and the electrical properties are excellent.

Third, the surface quality is high.

Devices fabricated based on the foregoing high-quality silicon carbide substrate has excellent performance, good consistency, as well as high reliability. The devices can meet a requirement on high-performance and high-reliability devices in fields of new energy vehicles, rail transportation, aerospace, smart grids, etc.

Hereinafter preferable embodiments of the present disclosure are described in conjunction with examples to facilitate better understanding of the present disclosure. It should be understood that these embodiments are only intended for further illustrating features and advantages of the present disclosure, rather than limiting claims of the present disclosure.

### First Embodiment: Manufacturing SiC seed crystal

In step S1, a primary seed crystal is provided. In the primary seed crystal, a density of micropipes is 2/cm², a density of threading screw dislocations is 1000/cm², and a density of mixed dislocations is 50/cm².

In step S2, a first diameter enlargement growth is performed. In the first diameter enlargement growth, an angle of diameter enlargement is selected to be 45°. An axial temperature gradient in a growth chamber is controlled as follows: temperature increases gradually from a surface of the primary seed crystal to a surface of the silicon carbide powder along a crystal growth direction with a gradient of 2°C/cm. A lateral temperature gradient is controlled as follows: the temperature increases gradually from a center of the primary seed crystal to a peripheral of the primary seed crystal along a radical direction with a gradient of 2°C/cm.

In step S3, the crystal obtained from the step S2 is cut and processed to obtain an intermediate seed crystal including an iso-diameter region and a diameter enlargement region. Then, the intermediate seed crystal is processed to obtain a high-quality intermediate seed crystal which includes only the diameter enlargement region.

In step S4, a second diameter enlargement growth is performed. In the second diameter enlargement growth, an angle of diameter enlargement is selected to be 45°. An axial temperature gradient in a growth chamber is controlled as follows: temperature increases gradually from a surface of the high-quality intermediate seed crystal to a surface of the silicon carbide powder along a crystal growth direction with a gradient of 2°C/cm. A lateral temperature gradient is controlled as follows: the temperature increases gradually from a center of the high-quality intermediate seed crystal to a peripheral of the high-quality intermediate seed crystal along a radical direction with a gradient of 2°C/cm.

The obtained crystal is cut along a direction parallel with a surface of the intermediate seed crystal to obtain an advanced seed crystal. The advanced seed crystal is 53mm in diameter and 500µm in thickness.

In step S5, a third diameter enlargement growth is performed. In the third diameter enlargement growth, an angle of diameter enlargement is selected to be 45°. An axial temperature gradient in a growth chamber is controlled as follows: temperature increases gradually from a surface of the advanced seed crystal to a surface of the silicon carbide powder along a crystal growth direction with a gradient of 2°C/cm. A lateral temperature gradient is controlled as follows: the temperature increases gradually from a center of the advanced seed crystal to a peripheral of the advanced seed crystal along a radical direction with a gradient of 2°C/cm.

The obtained crystal is cut in a direction parallel with a surface of the advanced seed crystal to obtain another advanced seed crystal. The other advanced seed crystal is 103mm in diameter and 500µm in thickness.

### Second Embodiment: Manufacturing silicon carbide powder

In step S1, graphite powder is pretreated as follows. High-purity graphite powder (in which a total concentration of impurities is smaller than 10ppm) is placed into a high-temperature furnace. The furnace is evacuated to vacuum and a vacuum pump keeps operating, then the furnace is heated to 2250°C, and the condition is maintained for 10h. When maintaining the condition, the vacuum pump is first shut down, the furnace is filled with argon gas to pressure of 50000Pa, such pressure is maintaining for 10min, then the vacuum pump is activated to evacuated the furnace to vacuum again, and the vacuum pump keeps operating. Thereby, the pretreated graphite powder is obtained.

In the pretreated graphite powder, a concentration of boron impurities is 5.5×10¹⁵/cm³, and a concentration of aluminum impurities is 4×10¹⁴/cm³.

In step S2, silicon powder and the pretreated graphite powder are mixed with a mass ratio of 1.00: 1. The mixture is placed into a graphite crucible in a high-temperature furnace, then the furnace is evacuated to vacuum, then the furnace was filled with argon gas to pressure of 5000Pa, and then the furnace is heated to 1900°C and kept for 8h, so as to obtain the silicon carbide powder.

### Third Embodiment: Manufacturing silicon carbide substrate

### I. Sample preparation

In step S 1, a graphite felt, which is a thermal insulation material, and a graphite crucible are pretreated. Operations and conditions of the pretreatment refer to the foregoing pretreatment on the graphite powder in the step S 1 of the second embodiment.

In step S2, the SiC seed crystal obtained from the first embodiment is adhesively fixed at a top inside a graphite lid, and the silicon carbide powder obtained in the second embodiment is loaded into the graphite crucible. The graphite lid with the SiC seed crystal is mounted on the graphite crucible. A distance between a surface of the silicon carbide powder and the SiC seed crystal is 40mm.

In step S3, the graphite crucible having the mounted lid, which is obtained from the step S2, is placed into a high-temperature furnace. The furnace is evacuated to pressure below 10Pa, then a vacuum pump keeps operating, and the furnace is heated to 800°C and maintained for 3h. When maintaining such condition, the vacuum pump is first shut down, the furnace is filled with argon gas to pressure 50000Pa, such pressure is maintained for 10min, then the vacuum pump is activated to evacuate the furnace to vacuum again, and the vacuum pump keeps operating.

In step S4, after the above treatment, the vacuum pump is shut down, the furnace is filled with argon gas to pressure 50000Pa, the furnace is heated to crystal growth temperature which is 2150°C, and the condition is maintained for 2h. Then, the pressure is reduced to required 1500Pa, and a crystal grows. After the crystal growth, the crystal is subject to in-situ annealing. Afterwards, the furnace is cooled to room temperature for fetching the crystal.

In step S5, the crystal is subject to cylindrical grinding, flat surface grinding, single-crystal orientation, wafer flat processing, and multi-wire cutting, so as to obtain a slice.

In step S6, each cut slice is subject to double-side grinding mechanical polishing, and chemical mechanical polishing, so as to obtain a high-quality silicon carbide substrate which is 100mm in diameter and 350µm in thickness.

The chemical mechanical polishing preferably includes a first chemical mechanical polishing and then a second chemical mechanical polishing.

The first chemical mechanical polishing utilizes an alumina polishing solution (in which D50 particle size of alumina is 200nm) and a polyurethane polishing pad (of which Shore hardness is 78). Pressure of a polishing head is 400g/cm², and a polishing rate is 1.5µm /hour.

The second chemical mechanical polishing utilizes a silicon dioxide polishing solution (in which D50 particle size of silicon dioxide is 100nm) and a nylon cloth polishing pad (of which Shore hardness is 65) . Pressure of a polishing head is 400g/cm², and a polishing rate is 35nm/hour.

### II. Sample testing

Crystal defects, impurity concentrations, surface quality, and electrical properties of the obtained silicon carbide substrate are tested, and results are as follows.

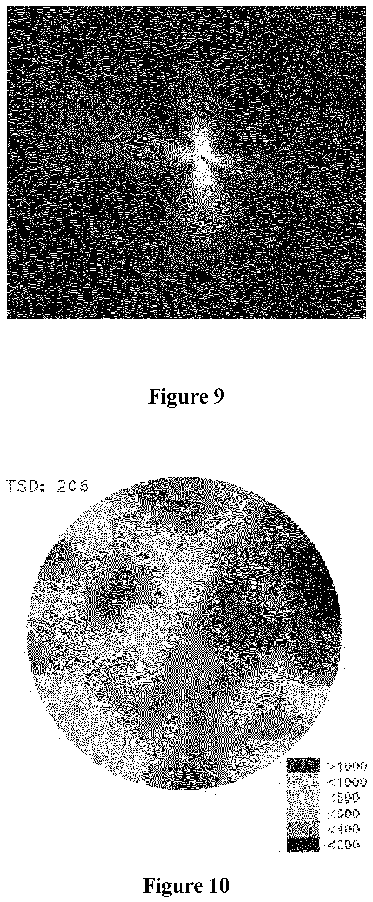

There was a high-quality region having a continuous area of 30cm², and defects in the region are as follows. There is no micropipe, a density of threading screw dislocations is 206/cm², a density of mixed dislocations is 8/cm², and a difference between full widths at half maximum of X-ray rocking curves at any two positions, between which a distance is equal to 1cm, is smaller than 20 arc seconds. The test results are as shown Figures 8 to 10. Figure 8 is a schematic diagram of distribution of micropipes in a silicon carbide substrate obtained according to the third embodiment. An area of the polygonal region having zero micropipe is 30cm². Figure 9 is a morphology image of the micropipes under transmission polarizing microscopy in a silicon carbide substrate obtained according to the third embodiment. Figure 10 is a schematic diagram of density distribution of threading screw dislocations in a silicon carbide substrate obtained according to the third embodiment.

Impurity concentrations are as follows. A concentration of boron impurities is 4.5×10¹⁵/cm³, and a concentration of aluminum impurities is 3.5×10¹⁴/cm³.

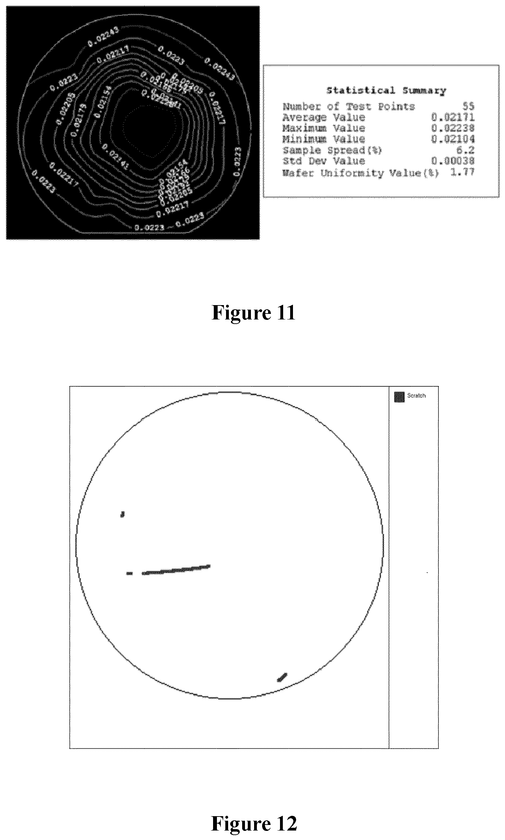

Electrical properties are as follows. Electrical resistivity is 0.022Ω·cm, with an non-uniformity of 1.77%. The test result is as shown in Figure 11. Figure 11 shows a graph of electrical properties of a silicon carbide substrate obtained according to the third embodiment. In Figure 11, the left half shows distribution of test data and the right half shows a result of generated data.

Surface quality is as follows. Accumulative length of scratches on a surface is only 0.6R (where R refers to the substrate radius, and test equipment is Candela CS920). The test results is as shown in Figure 12. Figure 12 shows a schematic diagram of scratches on a surface of a silicon carbide substrate obtained according to the third embodiment.

### Fourth Embodiment: Manufacturing SiC seed crystal

In step S1, a primary seed crystal is provided. In the primary seed crystal, a density of micropipes is 1/cm², a density of threading screw dislocations is 1000/cm², and a density of mixed dislocations is 30/cm².

In step S2, a first diameter enlargement growth is performed. In the first diameter enlargement growth, an angle of diameter enlargement is selected to be 30°. An axial temperature gradient in a growth chamber is controlled as follows: temperature increases gradually from a surface of the primary seed crystal to a surface of the silicon carbide powder along a crystal growth direction with a gradient of 3°C/cm. A lateral temperature gradient is controlled as follows: the temperature increases gradually from a center of the primary seed crystal to a peripheral of the primary seed crystal along a radical direction with a gradient of 2°C/cm.

In step S3, the crystal obtained from the step S2 is cut and processed to obtain an intermediate seed crystal including an iso-diameter region and a diameter enlargement region. Then, the intermediate seed crystal is processed to obtain a high-quality intermediate seed crystal which includes only the diameter enlargement region.

In step S4, a second diameter enlargement growth is performed. In the second diameter enlargement growth, an angle of diameter enlargement is selected to be 30°. An axial temperature gradient in a growth chamber is controlled as follows: temperature increases gradually from a surface of the high-quality intermediate seed crystal to a surface of the silicon carbide powder along a crystal growth direction with a gradient of 3°C/cm. A lateral temperature gradient is controlled as follows: the temperature increases gradually from a center of the high-quality intermediate seed crystal to a peripheral of the high-quality intermediate seed crystal along a radical direction with a gradient of 2°C/cm.

The obtained crystal is cut along a direction parallel with a surface of the intermediate seed crystal to obtain an advanced seed crystal. The advanced seed crystal is 53mm in diameter and 500µm in thickness.

In step S5, a third diameter enlargement growth is performed. In the third diameter enlargement growth, an angle of diameter enlargement is selected to be 30°. An axial temperature gradient in a growth chamber is controlled as follows: temperature increases gradually from a surface of the advanced seed crystal to a surface of the silicon carbide powder along a crystal growth direction with a gradient of 3°C/cm. A lateral temperature gradient is controlled as follows: the temperature increases gradually from a center of the advanced seed crystal to a peripheral of the advanced seed crystal along a radical direction with a gradient of 2°C/cm.

The obtained crystal is cut in a direction parallel with a surface of the advanced seed crystal to obtain another advanced seed crystal. The other advanced seed crystal is 103mm in diameter and 500µm in thickness.

In step S6, a fourth diameter enlargement growth is performed. In the fourth diameter enlargement growth, an angle of diameter enlargement is selected to be 30°. An axial temperature gradient in a growth chamber is controlled as follows: temperature increases gradually from a surface of the advanced seed crystal to a surface of the silicon carbide powder along a crystal growth direction with a gradient of 3°C/cm. A lateral temperature gradient is controlled as follows: the temperature increases gradually from a center of the advanced seed crystal to a peripheral of the advanced seed crystal along a radical direction with a gradient of 2°C/cm.

The obtained crystal is cut in a direction parallel with a surface of the other advanced seed crystal to obtain a third advanced seed crystal. The third advanced seed crystal is 153mm in diameter and 500µm in thickness.

### Fifth Embodiment: Preparing silicon carbide powder

In step S1, graphite powder is pretreated as follows. High-purity graphite powder (in which a total concentration of impurities is smaller than 10ppm) is placed into a high-temperature furnace. The furnace is evacuated to vacuum and a vacuum pump keeps operating, then the furnace is heated to 2200°C, and the condition is maintained for 30h. When maintaining the condition, the vacuum pump is first shut down, the furnace is filled with argon gas to pressure of 50000Pa, such pressure is maintaining for 10min, then the vacuum pump is activated to evacuated the furnace to vacuum again, and the vacuum pump keeps operating. Thereby, the pretreated graphite powder is obtained.

In the pretreated graphite powder, a concentration of boron impurities is 4.5×10¹⁵/cm³, and a concentration of aluminum impurities is 4.5×10¹⁴/cm³.

In step S2, silicon powder and the pretreated graphite powder are mixed with a mass ratio of 1.05: 1. The mixture is placed into a graphite crucible in a high-temperature furnace, then the furnace is evacuated to vacuum, then the furnace was filled with argon gas to pressure of 1000Pa, and then the furnace is heated to 1850°C and kept for 12h, so as to obtain the silicon carbide powder.

### Sixth Embodiment: Preparing silicon carbide substrate

### I. Sample preparation

In step S1, a graphite felt, which is a thermal insulation material, and a graphite crucible are pretreated. Operations and conditions of the pretreatment refer to the foregoing pretreatment on the graphite powder in the step S1 of the second embodiment.

In step S2, the SiC seed crystal obtained from the fourth embodiment is adhesively fixed at a top inside a graphite lid, and the silicon carbide powder obtained in the fifth embodiment is loaded into the graphite crucible. The graphite lid with the SiC seed crystal is mounted on the graphite crucible. A distance between a surface of the silicon carbide powder and the SiC seed crystal is 30mm.

In step S3, the graphite crucible having the mounted lid, which is obtained from the step S2, is placed into a high-temperature furnace. The furnace is evacuated to pressure below 10Pa, then a vacuum pump keeps operating, and the furnace is heated to 1000°C and maintained for 1h. When maintaining such condition, the vacuum pump is first shut down, the furnace is filled with argon gas to pressure 70000Pa, such pressure is maintained for 5min, then the vacuum pump is activated to evacuate the furnace to vacuum again, and the vacuum pump keeps operating.

In step S4, after the above treatment, the vacuum pump is shut down, the furnace is filled with argon gas to pressure 70000Pa, the furnace is heated to crystal growth temperature which is 2200°C, and the condition is maintained for 2.5h. Then, the pressure is reduced to required 2000Pa, and a crystal grows. After the crystal growth, the crystal is subject to in-situ annealing. Afterwards, the furnace is cooled to room temperature for fetching the crystal.

In step S5, the crystal is subject to cylindrical grinding, surface grinding, single-crystal orientation, wafer flat processing, and multi-wire cutting, so as to obtain a slice.

In step S6, each cut slice is subject to double-side grinding mechanical polishing, and chemical mechanical polishing, so as to obtain a high-quality silicon carbide substrate which is 150mm in diameter and 350µm in thickness.

The chemical mechanical polishing preferably includes a first chemical mechanical polishing and then a second chemical mechanical polishing.

The first chemical mechanical polishing utilizes an alumina polishing solution (in which D50 particle size of alumina is 200nm) and a polyurethane polishing pad (of which Shore hardness is 75). Pressure of a polishing head is 230g/cm², and a polishing rate is 1.1µm /hour.

The second chemical mechanical polishing utilizes a silicon dioxide polishing solution (in which D50 particle size of silicon dioxide is 100nm) and a nylon cloth polishing pad (of which Shore hardness is 60) . Pressure of a polishing head is 350g/cm², and a polishing rate is 25nm/hour.

### II. Sample testing

Crystal defects, impurity concentrations, surface quality, and electrical properties of the obtained silicon carbide substrate are tested, and results are as follows.

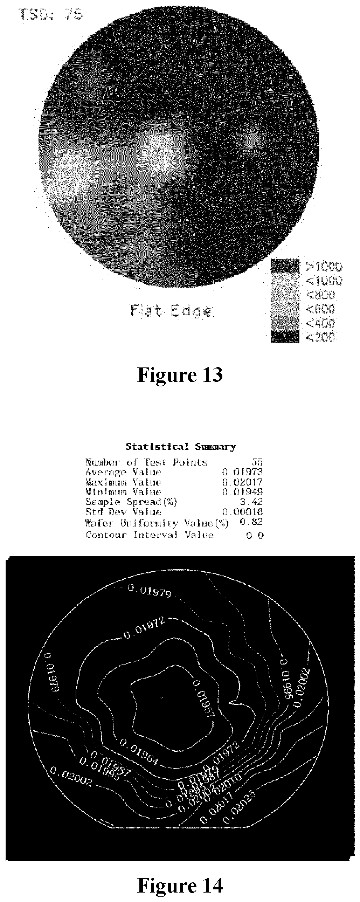

There was a high-quality region having a continuous area of 65cm², and defects in the region are as follows. There is no micropipe, a density of threading screw dislocations is 75/cm², a density of mixed dislocations is 6/cm², and a difference between full widths at half maximum of X-ray rocking curves at any two positions, between which a distance is equal to 1cm, is smaller than 20 arc seconds. The test result is as shown Figure 13. Figure 13 is a schematic diagram of distribution of threading screw dislocations in a silicon carbide substrate obtained according to the sixth embodiment.

Impurity concentrations are as follows. A concentration of boron impurities is 3.5×10¹⁵/cm³, and a concentration of aluminum impurities is 3.1×10¹⁴/cm³.

Electrical properties are as follows. Electrical resistivity is 0.02Q cm, with an non-uniformity of 0.82%. The test result is as shown in Figure 14. Figure 14 shows a graph of electrical properties of a silicon carbide substrate obtained according to the sixth embodiment. In Figure 14, the left half shows distribution of test data and the right half shows a result of generated data.

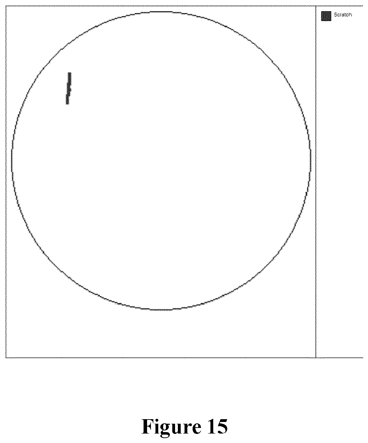

Surface quality is as follows. Accumulative length of scratches on a surface is only 0.3R (where R refers to the substrate radius, and test equipment is Candela CS920). The test results is as shown in Figure 15. Figure 15 shows a schematic diagram of scratches on a surface of a silicon carbide substrate obtained according to the sixth embodiment.

The foregoing embodiments show that in the silicon carbide substrate provided herein, the crystalline quality is high, the quantity of micropipes is quite small, the density of threading screw dislocations is quite low, and the density of mixed dislocations is quite low. Moreover, the concentration of p-type impurities is quite low, and electrical resistivity is excellent. The surface quality is high.

Specific examples are utilized herein to illustrate principles and embodiments of the present disclosure, and the foregoing description of embodiments is only intended for helping understand methods provided herein and core concepts, including the most preferable manner, thereof. The foregoing description of embodiments is also intended for enabling those skilled in the art to practice the present disclosure, which includes fabricating and using the devices or the systems and implementing any combination of the methods. It should be noted that those person of ordinary skill in the art can made various improvements and modifications to the present disclosure without departing from principles of the present disclosure, and these improvements and modifications also fall within the protection scope of claims of the present disclosure. The protection scope of the present disclosure is limited by the claims and may include another embodiment that can be made by those skilled in the art. In a case that such embodiment has structural elements that approximate the claims literally or includes equivalent structural elements that have no substantial difference from the claims literally, such embodiment shall also fall within the scope of the claims.

## Claims

1. A high-quality silicon carbide seed crystal, comprising at least a high-quality region, wherein:
in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and
an area of the high-quality region is larger than 0.25cm².

2. The silicon carbide seed crystal according to claim 1, wherein:
in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1cm, is smaller than 40 arc seconds; and
the area of the high-quality region is larger than 1cm².

3. The silicon carbide seed crystal according to claim 1, wherein:
in the high-quality region: the quantity of micropipes is zero, the density of threading screw dislocations is smaller than 50/cm², the density of mixed dislocations is smaller than 20/cm², and the difference between full widths at half maximum of X-ray rocking curves at any two positions, between which a distance is equal to 1cm, is smaller than 40 arc seconds; and
the area of the high-quality region is larger than 10cm²

4. The silicon carbide seed crystal according to claim 1, wherein:
in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds; and
the area of the high-quality region is larger than 50cm².

5. A method for manufacturing the high-quality silicon carbide seed crystal according to any one of claims 1 to 4, comprising:
step a), performing a first diameter enlargement growth based on a primary seed crystal to obtain a primary grown crystal;
step b), processing the primary grown crystal to obtain an intermediate seed crystal which comprises only a diameter enlargement region; and
step c) performing a second diameter enlargement growth based on the intermediate seed crystal to obtain an advanced seed crystal.

6. The method according to claim 5, wherein:
in the first diameter enlargement growth: an angle of diameter enlargement of the primary seed crystal inside a crucible is controlled to range from 5° to 50°, and temperature field distribution in a growth chamber is controlled to satisfy:
along an axial direction, temperature increases gradually from a surface of the primary seed crystal to a surface of a silicon carbide powder with a gradient ranging from 1°C/cm to 10°C/cm; and
along a lateral direction, temperature increases gradually from a center of the primary seed crystal to a peripheral of the primary seed crystal with a gradient ranging from 0.5°C/cm to 5°C/cm; and
in the second diameter enlargement growth: an angle of diameter enlargement of the intermediate seed crystal inside the crucible is controlled to range from 5° to 50°, and the temperature field distribution in the growth chamber is controlling to satisfy:
the along an axial direction, the temperature increases gradually from a surface of the intermediate seed crystal to a surface of a silicon carbide powder with a gradient ranging from 1 °C/cm to 10°C/cm; and
along a lateral direction, the temperature increases gradually from a center of the intermediate seed crystal to a peripheral of the intermediate seed crystal with a gradient ranging from 0.5°C/cm to 5°C/cm.

7. The method according to claim 5 or 6, wherein after the step c), the method further comprises step d):
comparing a diameter of the advanced seed crystal with a diameter of a silicon carbide substrate to be manufactured;
terminating the manufacturing in a case that the diameter of the advanced seed crystal is greater than or equal to the diameter of the silicon carbide substrate to be manufactured; and
repeating the second diameter enlargement growth based on the obtained advanced seed crystal in a case that the diameter of the advanced seed crystal is smaller than the diameter of the silicon carbide substrate to be manufactured, until the diameter of the obtained seed crystal is greater than or equal to the diameter of the silicon carbide substrate to be manufactured.

8. A high-quality silicon carbide crystal, formed by using the high-quality silicon carbide seed crystal according to any one of claims 1 to 4 or a high-quality silicon carbide seed crystal manufactured through the method according to any one of claims 5 to 7, wherein:
the silicon carbide crystal comprises at least a high-quality region;
in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and
an area of the high-quality region is larger than 0.25cm².

9. The silicon carbide crystal according to claim 8, wherein:
in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1cm, is smaller than 40 arc seconds; and
the area of the high-quality region is larger than 1cm².

10. The silicon carbide crystal according to claim 8, wherein:
in the high-quality region: the quantity of micropipes is zero, the density of threading screw dislocations is smaller than 50/cm², the density of mixed dislocations is smaller than 20/cm², and the difference between full widths at half maximum of X-ray rocking curves at any two positions, between which a distance is equal to 1cm, is smaller than 40 arc seconds; and
the area of the high-quality region is larger than 10cm².

11. The silicon carbide crystal according to claim 8, wherein:
in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds; and
the area of the high-quality region is larger than 50cm².

12. A method for manufacturing the silicon carbide crystal according to any one of claims 8 to 11, comprising:
placing a graphite crucible loaded with silicon carbide powder and mounted with the SiC seed crystal into a high-temperature furnace;
evacuating the furnace to lower pressure in the furnace and then filling a protective gas into the furnace to adjust the pressure, and simultaneously increasing temperature in the furnace, until reaching target pressure and target temperature; and
performing crystal growth under the target pressure and the target temperature to obtain the silicon carbide crystal..

13. The method according to claim 12, wherein the target pressure ranges from 100Pa to 5000Pa, and the target temperature ranges from 2050°C to 2250°C.

14. The method according to claim 12, wherein:
in the silicon carbide powder: a concentration of boron impurities is smaller than 5×10¹⁶/cm³ and a concentration of aluminum impurities is smaller than 5×10¹⁵/cm³;
in the graphite crucible: a concentration of boron impurities is smaller than 5×10¹⁶/cm³, and a concentration of aluminum impurities is smaller than 5×10¹⁵/cm³; and
in an thermal insulation material at periphery of the graphite crucible: a concentration of boron impurities is smaller than 5×10¹⁶/cm³, and a concentration of aluminum impurities is smaller than 5×10¹⁵/cm³.

15. The method according to claim 12 or 14, wherein the silicon carbide powder is prepared through:
step S1, mixing silicon powder and graphite powder to obtain a mixed powder; and
step S2, synthesizing the silicon carbide powder based on the mixed powder under a protective gas.

16. The method according to claim 15, wherein:
the graphite powder is pretreated graphite powder, which is obtained through calcining raw graphite powder in vacuum for a period ranging from 5h to 100h under a temperature ranging from 2200°C to 2400°C, and a total impurity content of the raw graphite powder is smaller than 10ppm;
the graphite crucible is a pretreated graphite crucible, which is obtained through calcining an original crucible in vacuum for a period ranging from 5h to 100h under a temperature ranging from 2200°C to 2400°C; and
the thermal insulation material is a pretreated thermal insulation material, which is obtained through calcining a raw thermal insulation material under in vacuum for a period ranging from 5h to 100h under a temperature ranging from 2200°C to 2400°C.

17. A high-quality silicon carbide substrate, comprising at least a high-quality region, wherein:
in the high-quality region: a quantity of micropipes is zero, a density of threading screw dislocations is smaller than 300/cm², a density of mixed dislocations is smaller than 20/cm², and a difference between full widths at half maximum of X-ray rocking curves at any two positions, between which a distance is equal to 1cm, is smaller than 40 arc seconds; and
an area of the high-quality region is larger than 0.25cm².

18. The silicon carbide substrate according to claim 17, wherein:
in the high-quality region: the quantity of micropipes is zero, the density of threading screw dislocations is smaller than 100/cm², the density of mixed dislocations is smaller than 20/cm², and the difference between full widths at half maximum of X-ray rocking curves at any two positions, between which a distance is equal to 1cm, is smaller than 40 arc seconds; and
the area of the high-quality region is larger than 1cm².

19. The silicon carbide substrate according to claim 17, wherein:
in the high-quality region: the quantity of micropipes is zero, the density of threading screw dislocations is smaller than 30/cm², the density of mixed dislocations is smaller than 5/cm², and the difference between full widths at half maximum of X-ray rocking curves at any two positions, between which a distance is equal to 1cm, is smaller than 20 arc seconds;
the area of the high-quality region is larger than 50cm²;
in the silicon carbide substrate, a concentration of boron impurities is smaller than 5×10¹⁵/cm³, and a concentration of aluminum impurities is smaller than 5×10¹⁴/cm³; and
a surface normal of the silicon carbide substrate deviates from c-axis orientation by an angle ranging from 1 degree to 5 degrees.

20. A method for manufacturing the high-quality silicon carbide substrate according to any one of claims 17 to 19, comprising:
step K1, processing the silicon carbide crystal according to any one of claims 8 to 11 or a silicon carbide crystal manufactured through the method according to any one of claims 12 to 16 to obtain a silicon carbide wafer; and
step K2, processing the silicon carbide wafer to obtain the silicon carbide substrate.

21. The preparation method according to claim 20, wherein processing the silicon carbide wafer processing comprises performing chemical mechanical polishing, wherein:
the chemical mechanical polishing comprises first chemical mechanical polishing and second chemical mechanical polishing;
the first chemical mechanical polishing utilizes alumina polishing solution and a polyurethane polishing pad having a Shore hardness ranging from 75 to 85;
the second chemical mechanical polishing utilizes silicon dioxide polishing solution and a nylon-cloth polishing pad having a Shore hardness ranging 60 to 75; and
a ratio of a polishing rate of the first chemical mechanical polishing to a polishing rate of the second chemical mechanical polishing ranges from 10 to 30.
